Europäisches Patentamt

European Patent Office

Office européen des brevets

(11) Publication number: **0 083 996**
**B1**

# EUROPEAN PATENT SPECIFICATION

(45) Date of publication of patent specification: **05.10.88**

(51) Int. Cl.⁴: **H 03 K 17/64, H 01 H 47/32**

(21) Application number: **83300175.3**

(22) Date of filing: **13.01.83**

(54) Electronic switching device with exciting coil.

(30) Priority: **13.01.82 JP 4172/82**

(43) Date of publication of application:
**20.07.83 Bulletin 83/29**

(45) Publication of the grant of the patent:
**05.10.88 Bulletin 88/40**

(84) Designated Contracting States:
**DE FR GB IT**

(56) References cited:
**DE-A-2 042 721**
**DE-A-2 941 075**
**GB-A-1 047 524**
**US-A-3 525 883**
**US-A-4 271 450**

(73) Proprietor: **OMRON TATEISI ELECTRONICS CO.**
**10, Tsuchido-cho Hanazono Ukyo-ku**
**Kyoto 616 (JP)**

(72) Inventor: **Ohashi, Takeo**
**31-6-202, Yamadaminami**
**Suita-shi Osaka (JP)**

(74) Representative: **Arthur, Bryan Edward et al**
**Withers & Rogers 4 Dyer's Buildings Holborn**
**London EC1N 2JT (GB)**

Courier Press, Leamington Spa, England.

## Description

This invention relates to an electronic switching device, and more particularly to an improved electronic switching device employing an electromagnetic switch for switching a load connected thereto.

There is well known in the control system field an electronic switching device which includes an electromagnetic switch and an electronic circuit driving the electromagnetic switch, such as an electronic timer, an electronic counter, a photoelectric switch, a logic relay and so on. Such a conventional electronic switching device is designed such that the electronic circuit, in response to an external input signal applied thereto or an internally developed signal, energises the electromagnetic switch so as to close or open its normally-opened or -closed contacts which are connected to a load to be switched. In order to keep the electromagnetic switch, e.g. an electromagnetic relay, in such a closed or opened position, the electronic circuit must continue to energise an exciting coil of the electromagnetic switch so as to close or open the contacts, which means that the energising coil consumes a relatively large electric power. Thus, the conventional device must be provided with a large electric power source, and is inappropriate as an energy saving type device.

It is an object of this invention to provide an electronic switching device with reduced electric power consumption.

U.S. 4,271,450 discloses an electronic switching circuit comprising a latching relay having a relay winding connected in series with a capacitor and a semiconductor switch in a switching circuit which is so arranged that when a voltage of a predetermined polarity is applied to a pair of terminals of said switching circuit said semiconductor switch is biased off and said relay is set in a first state by charging current through said capacitor and when said voltage is removed said semiconductor switch is biased on and said capacitor discharges through said relay winding to set the relay in a second state.

The present invention is characterised in that said voltage is applied and removed by means of a series combination of a further capacitor and further semiconductor switch connected across said terminals, said further capacitor being connected in series with current limiting means in a charging circuit and said further semiconductor switch being controlled by a control circuit which is energised from said charging circuit.

The latching relay may be a polarized electromagnet relay employing a permanent magnet, or a stepping relay, and so forth. The invention allows the relay to be actuated to a set or a reset position by a momentary application of power from the further capacitor, whereby the power source for the device can be reduced to such a small power capacity that it charges the further capacitor with a relatively low current for a predetermined charging time duration, with the result that the power consumption of the electronic switching device is reduced.

The invention will now be described by way of example with reference to the accompanying drawings, in which:-

Figure 1 is a schematic circuit block diagram showing an electronic switching device which is employed as an electronic timer as a preferred embodiment of the invention;

Figure 2 is a graphical representation of the voltage waveforms produced in operation of the device of Figure 1;

Figure 3 is a schematic circuit block diagram showing a modified electronic switching device; and

Figure 4 is a schematic circuit block diagram showing an electronic switching device employing a switching regulator as a modification of the embodiment of Figure 3.

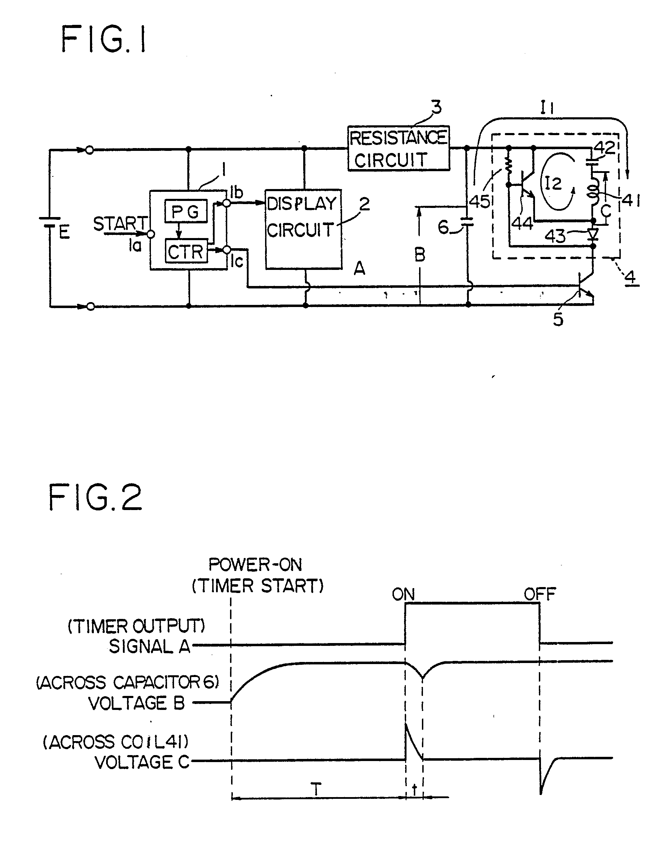

Referring to Figure 1, a first embodiment of an electronic switching device in accordance with the invention is an electronic timer including a timer circuit 1 as signal generating means and a display circuit 2 which are connected in parallel with a d.c. power source E. The d.c. power source E is further connected with a resistance circuit or a resistance 3 having a relatively high impedance as current regulating means, a latching type relay circuit 4, a switching transistor 5 as first switching means, and a first charging-and-discharging capacitor 6.

The timer circuit 1 is of conventional construction, including a clock pulse generator PG and a pulse counter CTR. In operation, when the counter CTR has counted up a predetermined number of clock pulses generated by the clock pulse generator PG in accordance with a desired time duration preset in the timer circuit, it provides the base of the transistor 5 with an output signal, e.g., a high level output signal. The timer circuit 1 comprises an integrated C-MOS circuit whose power consumption is extremely small. The display circuit 2 is supplied with a time signal developed from the counter CTR in the timer circuit 1 so as to display a time elapsing in the circuit 1. In order to reduce power consumption in the present device, the display circuit 2 employs a liquid crystal display or the like.

The capacitor 6 is charged through the resistance 3 while the timer circuit 1 counts a predetermined preset time, and when the predetermined preset time has been counted up, the capacitor 6 provides the circuit 4 with a discharged power therefrom.

The latching type relay circuit 4 includes an exciting coil 41 which is part of a latching type electromagnetic relay set by a positive current applied to the coil 41 and reset by a negative current applied thereto. The relay may be polarized relay employing a permanent magnet. The circuit 4 further includes a second charging-and-discharging capacitor 42, a diode 43, a switching transistor 44 as second switching means, and a resistance 45, which are arranged with the transistor 5 to set or reset the relay on the basis of a momentary power discharge from the capacitor 6. The capacitor 42 is adapted to be charged by the discharged power from the capacitor 6 so as to provide the coil 41 with a reversal current or a negative discharging current to reset the relay of the coil 41 when transistor 5 is turned off.

Referring to Figure 2, when the d.c. power source E is applied to the device of Figure 1, the timer circuit 1 is initiated to count a predetermined preset time, and its output signal A at its output terminal 1c is at a low level as illustrated. At this time, the transistor 5 is switched off or turned off, i.e. nonconductive, no energy being applied to the coil 41, and the capacitor 6 is charged by the power source E through the resistance 3. When the counter circuit 1 counts up to a first predetermined preset time, its output signal A changes to a high level, so that the transistor 5 is switched or turned on, i.e. made conductive, and power discharged momentarily from the capacitor 6 is applied to the coil 41 through the capacitor 42 while the transistor 44 is turned off. The relay, having its coil 41 energised, is set so as to close its normally opened contacts (not shown in drawings). That is, when the output signal A from the timer circuit 1 becomes high, a positive discharging or energising current flows through the coil 41 for a time period shown in Figure 2, until the charge in the capacitor 42 is saturated. Such a momentary energising current sets the relay of the coil 41, and the relay keeps such a set position that the normally opened contacts remain closed without any energy applied to the coil 41.

When the timer circuit 1 counts up a second predetermined preset time, the output signal A returns to the low level, so that the transistor 5 is turned off, and the transistor 44 is turned on by bleeder resistances comprising the resistance 45 and the reverse biassed high resistance diode 43. The charge on capacitor 42 is discharged through the transistor 44, from the collector to the emitter thereof, so as to provide the coil 41 with a momentary reversal current or a negative discharging current. Such a momentary reversal current flows through the coil 41 until the capacitor 42 is completely discharged by the coil 42, and the relay of the coil 41 is reset so as to open the normally-opened contacts.

Thus, in this embodiment, the latching type relay employing an exciting coil 41 is set by a momentary power discharged from the capacitor 6 and is reset by a momentary power discharged from the capacitor 42 charged by the capacitor 6. Since the total energy for setting and resetting the relay is supplied from the capacitor 6 which is fully charged with a small current through the resistance 3 from the power source E and consumed on setting or resetting the relay, a reduced power source may be employed as the source E and no energy is needed to keep the relay in a set or reset position. Moreover, since the timer circuit 1 employs a C-MOS integrated circuit and the display circuit 2 employs a liquid crystal display, the electronic timer of Figure 1 is very advantageous for saving energy. Particularly, the device of Figure 1 is advantageous when the power source E is designed for a multi-range power source capable of converting an external power source ranging, e.g. from 12 V to 240 V d.c./a.c., to a predetermined voltage applicable to the device.

For example, the device of Figure 1 may be designed such that the resistance 3 is 1,000 ohms, the capacitor 6 is 500 microfarads, the capacitor 42 is 10 microfarads, and a minimum current for exciting the coil 41 is 100 milliamperes. When a 10 milliampere maximum and 12 volt d.c. power source is employed as the source E, the capacitor 6 is fully charged in 0.5 second from the timer start time point and the coil 41 can be properly excited in either current direction. Thus, the power source E is reduced from $100mA \times 12V$ power to $10mA \times 12V$ power.

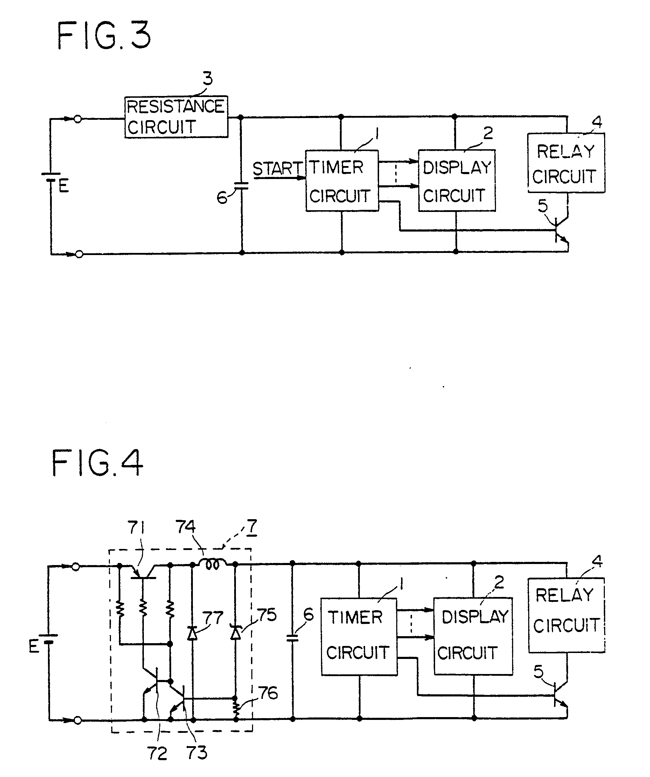

In Figure 3, there is shown a device which is a modification of that of Figure 1 in which the resistance circuit 3 and the capacitor 6 are interposed between the power source E and the timer circuit 1. In this modified embodiment, there are provided the same operations and advantages as those in the device of Figure 1. Though the power supplied to the timer circuit 1 is instantaneously dropped to a certain extent on turning on the transistor 5 so as to discharge the capacitor 6, the timer circuit 1 comprises a C-MOS integrated circuit which is usable with a power source varying over a relatively wide voltage range, so that such a drop does not affect the operation of the circuit 1. Moreover, even if the power applied to the display circuit 2 drops instantaneously, the circuit 2 does not exhibit any visible defect.

Referring to Figure 4, in a further modified device the resistance circuit 3 of Figure 3 is replaced by a switching regulator 7 as the current regulating means. The regulator 7 is a conventional circuit which includes transistors 71, 72 and 73, a coil 74, a Zener diode 75, a resistance 76 and a diode 77. Transistors 71 to 73 constitute a self-driving type oscillating circuit. When power is applied to circuit 7, the transistor 71 is turned on so that an electric current flows through the emitter and collector of the transistor 71 and through the coil 74 to the timer circuit 1, the display circuit 2 and the capacitor 6. The capacitor 6 is charged upto a predetermined level, so that the diode 75 is turned on. At this time, the transistor 73 is turned on and the transistors 72 and 71 are turned off, so that no electric current flows from the transistor 71 to the coil 74. But, energy previously stored in the coil 74 is discharged through the diode 77 to the circuit 1 and so forth. Upon the complete exhaustion of the energy stored in the coil 74, the power applied to the circuit 1 and so forth drops so that the diode 75 is turned off. The transistor 73 is then turned off and the transistors 72 and 71 are turned on, so that an electric current again flows through the transistor 71 to the circuit 1 and so forth. By repeating the above-mentioned operations, the regulator 7 can provide the circuits 1 and 2 and the capacitor 6 with regulated electric power. The switching regulator 7 in this embodiment is designed to have a low impedance, e.g. 20 ohms, to be powered by an unstable external power source, e.g. varying between 12V and 240V, and to generate a predetermined regulated voltage, e.g. 5V, controlled by the Zener diode 75. The regulator 7, however, may employ a relatively small capacity type regulator, e.g. capable of generating 10 milliampere output current in spite of a large current relay circuit 4 requiring about a 100 milliampere exciting current, because the circuits 1, 2, 4, 5 and 6 are designed to consume an extremely reduced power. Instead of the switching regulator 7, a d.c./d.c. convertor may be employed.

As another modification of the foregoing embodiments, the timer circuit 1 may be replaced by any equivalent logic circuit generating an output signal as illustrated by waveform A of Figure 2, such as the detecting circuit of a photoelectric switch, a proximity switch, an ultrasonic sensing switch or the like. If desired, the display circuit 2 may be omitted. Moreover, by omitting the circuits 1 and 2, the modified electronic switching device may be used as a logic circuit in which an external input signal is applied directly to the base of the transistor 5 or indirectly through an input circuit to the same so as to provide the transistor 5 with a signal similar to the waveform A. It should be understood, however, that in any of above-mentioned modifications, the transistor 5 should not be turned on or off within a predetermined time period. For example, the transistor 5 should not be turned off within the period t in Figure 2, when the capacitor 42 is being charged.

## Claims

1. An electronic switching circuit comprising a latching relay having a relay winding (41) connected in series with a capacitor (42) and a semiconductor switch (44) in a switching circuit (4) which is so arranged that when a voltage of a predetermined polarity is applied to a pair of terminals of said switching circuit (4) said semiconductor switch (44) is biased off and said relay is set in a first state by charging current through said capacitor (42) and when said voltage is removed said semiconductor switch (44) is biased on and said capacitor (42) discharges through said relay winding (41) to set the relay in a second state, characterised in that said voltage is applied and removed by means of a series combination of a further capacitor (6) and further semiconductor switch (5) connected across said terminals, said further capacitor (6) being connected in series with current limiting means (3,7) in a charging circuit and said further semiconductor switch (5) being controlled by a control circuit (1) which is energized from said charging circuit.

2. An electronic switching circuit as claimed in Claim 1, wherein said control circuit (1) is a timer circuit.

3. An electronic switching circuit as claimed in Claim 2, wherein a display circuit (2) is coupled to said timer circuit (1) and arranged to display elapsed time.

4. An electronic switching circuit as claimed in any preceding claim wherein said current-limiting means (3, 7) comprises a resistance (3).

5. An electronic switching circuit as claimed in any of Claims 1 to 3 wherein said current-limiting means (3, 7) comprises a switching regulator (7).

6. An electronic switching circuit as claimed in any preceding claim wherein said control circuit (1) is connected directly across said terminals, said current limiting means (3, 7) being connected between said control circuit (1) and said further capacitor (6).

7. An electronic circuit as claimed in Claim 6 as dependent on Claim 3, wherein said display circuit (2) is connected directly across said terminals.

## Patentansprüche

1. Elektronische Schalt-Schaltung, welche ein Verriegelungsrelais mit einer mit einem Kondensator (42) in Reihe geschalteten Relaiswicklung (41) und einen Halbleiterschalter (44) in einer Schalt-Schaltung (4) umfaßt, die so eingerichtet ist, daß, wenn eine Spannung einer bestimmten Polarität auf ein Paar von Anschlüssen der Schalt-Schaltung (4) gegeben wird, der Halbleiterschalter (44) in den Aus-Zustand vorgespannt und das Relais in einen ersten Zustand durch Ladestrom durch den Kondensator (42) gesetzt wird, und daß, wenn die Spannung entfernt wird, der Halbleiterschalter (44) in den Ein-Zustand vorgespannt wird und der Kondensator (42) sich durch die Relaiswicklung (41) entlädt und so das Relais in einen zweiten Zustand gesetzt wird, dadurch gekennzeichnet, daß die Spannung mittels einer zwischen den Anschlüssen angeschlossene Reihenkombination aus einem weiteren Kondensator (6) und weiteren Halbleiterschalter (5) angelegt und entfernt wird, wobei der weitere Kondensator (6) mit Strombegrenzermitteln (3, 7) in einer Ladeschaltung in Reihe geschaltet ist und der weitere Halbleiterschalter (5) durch eine Steuerschaltung (1) gesteuert wird, welche durch die Ladeschaltung erregt wird.

2. Elektronische Schalt-Schaltung nach Anspruch 1, bei welcher die Steuerschaltung (1) eine Zeitgeberschaltung ist.

3. Elektronische Schalt-Schaltung nach Anspruch 2, bei welcher eine Anzeigeschaltung (2) mit der Zeitgeberschaltung (1) gekoppelt und so eingerichtet ist, daß sie verstrichene Zeit anzeigt.

4. Elektronische Schalt-Schaltung nach irgendeinem vorstehenden Anspruch, bei welcher die Strombegrenzermittel (3, 7) einen Widerstand (3) umfassen.

5. Elektronische Schalt-Schaltung nach irgendeinem der Ansprüche 1 bis 3, bei welcher die Strombegrenzermittel (3, 7) einen Sperrwandler (7) umfassen.

6. Elektronische Schalt-Schaltung nach irgendeinem vorstehenden Anspruch, bei welcher die Steuerschaltung (1) direkt zwischen den Anschlüssen angeschlossen ist, wobei die Strombegrenzermittel (3, 7) zwischen der Steuerschaltung (1) und dem weiteren Kondensator (6) angeschlossen sind.

7. Elektronische Schaltung nach Anspruch 6 in Rückbezug auf Anspruch 3, bei welcher die Anzeigeschaltung (2) direkt zwischen den Anschlüssen angeschlossen ist.

**Revendications**

1. Circuit de commutation électronique comprenant un relais de verrouillage avec un bobinage de relais (41) relié en série avec une capacité (42) et un commutateur à semiconducteur (44) dans un circuit de commutation (4) qui est conçu de telles sorte que lorsqu'une tension d'une polarité prédéterminée est appliquée à une paire de bornes dudit circuit de commutation (4) ledit commutateur à semiconducteur (44) est mis hors circuit et ledit relais est amené dans un premier étar par un courant de charge s'écoulant à travers ladite capacité (42) et quand ladite tension est supprimée ledit commutateur à semiconducteur (44) est fermé et ladite capacité (42) se décharge à travers ledit bobinage de relais (41) pour amener le relais dans un deuxième état, caractérisé en ce que ladite tension est appliquée et coupée au moyen d'une combinaison en série d'une autre capacité (6) et d'un autre commutateur à semiconducteur (5) connecté auxdites bornes, ladite autre capacité (6) étant connectée en série avec des moyens de limitation de courant (3, 7) dans un circuit de charge et ledit autre autre commutateur à semiconducteur (5) étant commandé par un circuit de commande (1) qui est alimenté à partir dudit circuit de charge.

2. Circuit de commutation électronique tel que revendiqué dans la revendication 1, dans lequel ledit circuit de commande (1) est un circuit de cadencement.

3. Circuit de commutation électronique tel que revendiqué dans la revendication 2 dans lequel un circuit de visualisation (2) est couplé audit circuit de cadencement (1) et disposé pour visualiser le temps écoulé.

4. Circuit de commutation électronique tel que revendiqué dans l'une quelconque des revendications précédentes dans lequel ledit moyen de limitation du courant (3, 7) comporte une résistance (3).

5. Circuit de commutation électronique tel que revendiqué dans l'une quelconque des revendications 1 à 3 dans lequel ledit moyen de limitation de courant (3, 7) comporte un régulateur de commutation (7).

6. Circuit de commutation électronique tel que revendiqué dans l'une des quelconques des revendications précédentes dans lequel le circuit de commande (1) est connecté directement auxdites bornes, ledit moyen de limitation de courant (3, 7) étant relié entre ledit circuit de commande (1) et ladite autre capacité (6).

7. Circuit électronique tel que revendiqué dans la revendication 6 lorsqu'elle dépend de la revendication 3, dans lequel ledit circuit de visualisation (2) est connecté directement auxdites bornes.

# FIG.1

# FIG.2

POWER-ON
(TIMER START)

ON          OFF

(TIMER OUTPUT)
SIGNAL A

(ACROSS CAPACITOR 6)
VOLTAGE B

(ACROSS COIL 41)
VOLTAGE C

T          t

1

# FIG.3

RESISTANCE CIRCUIT

3

E

6

START TIMER CIRCUIT

1

DISPLAY CIRCUIT

2

RELAY CIRCUIT

4

5

# FIG.4

71  74  7

E

72  73

77  75

76

6

TIMER CIRCUIT

1

DISPLAY CIRCUIT

2

RELAY CIRCUIT

4

5